# EUROPÄISCHE PATENTSCHRIFT

(11) **EP 1 285 493 B1**
(45) Veröffentlichungstag und Bekanntmachung des Hinweises auf die Patenterteilung: **08.03.2006**
(21) Anmeldenummer: 01947129.1
(22) Anmeldetag: 04.05.2001
(51) Int. Cl.: H03D 1/00

(54) **SCHALTUNGSANORDNUNG ZUR TOLERANZKORREKTUR IN EINEM FREQUENZDEMODULATOR**
CIRCUIT ARRANGEMENT FOR CORRECTING TOLERANCES
MONTAGE DE CORRECTION DE TOLERANCE

(30) Priorität: 16.05.2000 DE 10023873
(43) Veröffentlichungstag der Anmeldung: 26.02.2003
(73) Patentinhaber: Infineon Technologies AG, 81669 München (DE)
(72) Erfinder: WAGNER, Elmar, 47269 Duisburg (DE); HEINEN, Stefan, 47802 Krefeld (DE); HANKE, Andre, 40468 Düsseldorf (DE)
(74) Vertreter: Epping - Hermann - Fischer
(86) Internationale Anmeldenummer: PCT/DE2001/001704
(87) Internationale Veröffentlichungsnummer: WO 2001/089077

(56) Entgegenhaltungen:
- EP-A- 0 255 175
- EP-A- 0 574 083
- EP-A- 0 948 128
- DE-A- 3 613 994
- FR-A- 2 207 284

## Beschreibung

Die Erfindung betrifft eine Schaltungsanordnung zur Korrektur fertigungsbedingter Toleranzen.

Bei normalerweise zur Chipherstellung eingesetzten Technologien treten üblicherweise unvermeidliche Schwankungen bei den Fertigungs- und Prozeßparametern auf. So kann beispielsweise die Schichtdicke integrierter elektrischer Bauelemente in Abhängigkeit von Fertigungsparametern, wie Temperaturen oder Verweilzeiten in einzelnen Prozeßschritten stark schwanken. Hierdurch werden die elektrischen Kenngrößen der integrierten elektrischen Bauteile ebenfalls toleranzbehaftet sein. Kondensatoren unterliegen normalerweise Toleranzen von +/- 10 % bezüglich ihrer elektrischen Kapazität, welche von der Dicke des Dielektrikums abhängt. Widerstände, deren Widerstandswerte sowohl von Leitfähigkeitsparametern als auch von der Schichtdicke des Dielektrikums abhängen, sind üblicherweise Toleranzen von +/- 15 % unterworfen. Folglich sind alle Parameter von Schaltungen, die von Widerstands- oder Kapazitätswerten abhängen, ebenfalls fertigungsbedingten Schwankungen unterworfen.

Voll integrierte Hochfrequenz-Empfänger können auf einem einzigen Chip integriert sein. Ein derartiger Chip weist eine Vielzahl von toleranzbehafteten integrierten Bauteilen auf. Absolut betrachtet sind die Parameter der integrierten Bauteile zwar starken Schwankungen unterworfen, die Toleranzen der auf dem gleichen Chip integrierten Bauteile untereinander sind aber sehr gering, da diese bei der Fertigung den gleichen Fertigungsparametern unterworfen sind.

In Hochfrequenz-Empfängern sind zahlreiche integrierte Bauteile, wie beispielsweise aktive Filter, Demodulatoren, Mischer et cetera durch charakteristische Frequenzen gekennzeichnet. Beispielsweise die Grenzfrequenz eines Tiefpaßfilters oder die Mittenfrequenz eines Bandpaßfilters hängen von Zeitkonstanten ab, welche durch das Produkt von Widerstandswert und Kapazitätswert gebildet und folglich.Toleranzen unterworfen sind. Da bei Hochfrequenz-Empfängern die charakteristischen Frequenzen nur in engen Grenzen Toleranzen aufweisen dürfen, sind die Anforderungen an die Genauigkeit der Kapazitätswerte der Kondensatoren und der Widerstandswerte der Widerstände sehr hoch.

Üblicherweise werden die Toleranzen der Widerstände korrigiert, indem ein chipinterner Widerstand mit einem externen Widerstand verglichen wird. In Abhängigkeit der Abweichung des tatsächlichen Widerstandswertes von einem Sollwert werden dann Widerstände oder Kondensatoren, welche bereits auf dem Chip integriert sind, zugeschaltet, um Abweichungen des Produkts aus Widerstand und Kapazitätswert von einem Sollwert weitestgehend zu korrigieren. Das beschriebene Prinzip weist den Nachteil auf, daß die Abweichungen der Kapazitätswerte von Sollwerten nicht erfaßt werden und folglich auch nicht korrigiert werden können. Hierdurch kann die Kompensation der Abweichungen des Produkts aus Widerstandswert und Kapazitätswert vom Sollwert unzureichend sein.

Beispiele für bekannte Frequenzdemodulatoren sind in DE 3613994 A oder EP 0948128 A angegeben.

Aufgabe der vorliegenden Erfindung ist es, eine Schaltungsanordnung zur Toleranzkorrektur von integrierten Widerständen und Kapazitäten anzugeben, bei der sowohl die Abweichungen des Kapazitätswertes als auch des Widerstandswertes erfaßbar sind.

Erfindungsgemäß wird die Aufgabe von einer Schaltungsanordnung zur Toleranzkorrektur gelöst, aufweisend die Merkmale des vorliegenden Patentanspruchs 1.

Der Erfindung liegt das Prinzip zugrunde, einen Detektor an den Ausgang eines Frequenzdemodulators anzuschließen, so daß bei Anlegen eines Referenzsignals an den Eingang des Demodulators, der einen einstellbaren Widerstand oder eine einstellbare Kapazität aufweist, am Ausgang des Demodulators ein Signal anliegt, welches neben seiner Abhängigkeit vom Eingangssignal zusätzlich vom Widerstand und der Kapazität, von denen zumindest ein Bauteil einstellbar ausgeführt ist, abhängt. Im Detektor kann somit die Abweichung des Ausgangssignals von einem bei Anlegen eines Referenzsignals erwarteten Soll-Ausgangssignal beispielsweise mit einem Fensterdiskriminator erfaßt werden. In Abhängigkeit von der Abweichung des Ausgangssignals von einem Sollsignal, das heißt in Abhängigkeit von einer Frequenzabweichung des Demodulators, können der einstellbare Widerstand oder die einstellbare Kapazität bezüglich ihres Widerstandswerts beziehungsweise Kapazitätswerts verändert werden. Beispielsweise durch Ausprobieren oder durch geeignete Approximationsverfahren können Widerstands- oder Kapazitätswert solange verändert werden, bis eine Abweichung des Ausgangssignals des Demodulators von dem gewünschten Sollsignal Null oder minimal ist. Somit ist es möglich, die Toleranzen toleranzbehafteter Kondensatoren und Widerstände zu korrigieren.

Die beschriebene Anordnung hat den Vorteil, daß durch Erfassung der in einem Normalbetrieb relevanten Auswirkungen von Abweichungen der Widerstands- oder Kapazitätswerte auf RC-Zeitkonstanten und zugeordnete charakteristische Frequenzen wie Mitten- oder Grenzfrequenzen eine sehr genaue Korrektur fertigungsbedingter Toleranzen ermöglicht ist.

Die Korrekturen der Widerstandswerte oder Kapazitätswerte können zur Korrektur anderer Bauteile mit benutzt werden, ohne diese separat ausmessen zu müssen. Denn die Toleranzen von Bauteilen, welche den gleichen Fertigungsparametern unterworfen waren, also beispielsweise auf dem gleichen Chip integriert sind, haben untereinander nur sehr geringe Abweichungen. Wenn bei der beschriebenen Toleranzkorrektur beispielsweise der Wert eines Widerstands um 10 % erhöht wurde, um dessen Toleranz zu kompensieren, so führt eine Erhöhung der Widerstandswerte aller anderen Widerstände auf dem gleichen Chip um 10 % ebenfalls zur Kompensation von deren Toleranzen.

In einer vorteilhaften Ausgestaltungsform der vorliegenden Erfindung können Widerstands- und Kapazitätswert korrigiert werden. Hierzu sind Widerstand und Kapazität einstellbar ausgeführt.

In der vorliegenden Erfindung ist der Demodulator ein Frequenzdemodulator, der in einer vorteilhaften Ausführungsform der Frequenz eines am Eingang anliegenden Signals eine am Ausgang abgreifbare Spannung zuordnet. Beispielsweise weist ein Quadrikorrelator eine Mittenfrequenz auf. Diese Mittenfrequenz kann von einer Soll-Mittenfrequenz dadurch abweichen, daß eine der Mittenfrequenz zugeordnete, zu einem Produkt aus Widerstand und Kapazität proportionale Zeitkonstante von einem Sollwert abweicht. Speist man ein Signal mit der Soll-Mittenfrequenz des Quadrikorrelators, die von der tatsächlichen Mittenfrequenz des Quadrikorrelators abweichen kann, an dessen Eingang ein, so liegt am Ausgang des Quadrikorrelators ein Ausgangssignal an, welches eine Abweichung von einem Soll-Wert haben kann. Diese Abweichung ist vom Produkt aus Widerstandswert und Kapazitätswert abhängig und somit kann auf die Toleranzen von Widerstandswert und Kapazitätswert rückgeschlossen werden. Beispielsweise mit dem Verfahren der sukzessiven Approximation (Wägeverfahren) kann mittels des Detektors die Abweichung der Mittenfrequenz von einer Soll-Mittenfrequenz korrigiert werden. Hierzu wird die Abweichung der Ausgangsspannung von einer Sollspannung ausgewertet und in Abhängigkeit davon können die Widerstände und Kondensatoren solange verstellt werden, bis die Abweichung der Ausgangsspannung von einem Sollwert verschwindet oder zumindest verringert ist.

Selbstverständlich kann es genügen, lediglich den Widerstandswert oder den Kapazitätswert zu verstellen, um den gewünschten Erfolg zu erzielen, nämlich die Abweichung der Ausgangsspannung von einem Sollwert zu verringern oder verschwinden zu lassen.

Zur Toleranzkorrektur weiterer Bauelemente, welche auf dem gleichen Chip wie der Demodulator angeordnet sein können, ist es nun möglich, die gewonnenen Korrekturwerte von Widerstandswert oder Kapazitätswert oder beiden heranzuziehen.

In einer weiteren, vorteilhaften Ausführungsform der vorliegenden Erfindung ist zur Erzeugung einer Referenzfrequenz ein Frequenzgenerator an den Eingang des Demodulators angeschlossen. Dieser Frequenzgenerator kann die Soll-Mittenfrequenz eines Quadrikorrelators oder eine andere, charakteristische Frequenz bei einem Demodulator erzeugen und dem Demodulator-Eingang zuführen.

In einer weiteren, vorteilhaften Ausführungsform der vorliegenden Erfindung hat der Demodulator eine Soll-Mittenfrequenz, welche gleich der Referenzfrequenz des Frequenzgenerators ist.

In einer weiteren, vorteilhaften Ausführungsform der vorliegenden Erfindung ist dem Detektor eine Sollspannung zum Vergleich mit der Ausgangsspannung zuführbar. Diese Sollspannung kann extern, das heißt außerhalb des Detektors beispielsweise durch Verwendung einer Referenzspannung erzeugt werden, oder intern im Detektor bereitgestellt sein..

In einer weiteren, vorteilhaften Ausführungsform der vorliegenden Erfindung beträgt die Sollspannung 0 Volt. Beispielsweise bei Quadrikorrelatoren beträgt die Ausgangsspannung 0 Volt, wenn am Eingang die Mittenfrequenz des Demodulators anliegt.

In einer weiteren, vorteilhaften Ausführungsform der vorliegenden Erfindung weist der Demodulator weitere Kondensatoren auf, die dem Kondensator zuschaltbar sind, oder weitere Widerstände, die dem Widerstand zuschaltbar sind. Hierdurch kann die Verstellung von Widerstand oder Kapazität im Demodulator erfolgen. Die weiteren Widerstände können parallel oder seriell zum Widerstand schaltbar sein, die weiteren Kondensatoren können parallel oder seriell zum Kondensator schaltbar sein. Die Abstufungen der weiteren Widerstände und weiteren Kondensatoren bezüglich ihres Widerstands- beziehungsweise Kapazitätswert ist in Abhängigkeit vom verwendeten Approximationsverfahren sowie der üblicherweise auftretenden Abweichungen von den Sollwerten vorzunehmen.

In einer weiteren, vorteilhaften Ausführungsform der vorliegenden Erfindung ist der Demodulator in einem Zwischenfrequenzpfad eines Hochfrequenz-Empfängers angeordnet. Besonders bei hochintegrierten Empfängern zur Anwendung im Mobilfunk, beispielsweise in Mobiltelefonen oder Schnurlostelefonen, die bezüglich Gewicht, Platzbedarf und Energieverbrauch hohen Anforderungen unterworfen sind, ist die Kompensation fertigungsbedingter Toleranzen der integrierten Bauelemente von großer Bedeutung. Zur Umschaltung des Demodulator-Eingangs von einem im Normalbetrieb zuführbaren Nutzsignal auf ein in einem Einstellbetrieb zuführbaren Referenz-Signal mit einer Referenzfrequenz zur Einstellung der Widerstände und Kondensatoren kann ein Schalter am Eingang des Demodulators angeschlossen sein. Bei einem Empfänger mit niedriger Zwischenfrequenz, welche zwischen 0 und mehreren Megahertz liegen kann, und bei hohen Datenraten von beispielsweise 1 Megabit pro Sekunde weist ein Zwischenfrequenzpfad meist einen I- und einen Q-Pfad für die Quadraturkomponenten auf. In diesem Fall kann das normalerweise vorhandene Polyphasenfilter zur Kanalfilterung, welches dem Demodulator vorgeschaltet ist, im Einstellbetrieb ein dem Polyphasenfilter am Eingang zuführbares Referenz-Signal so aufbereiten, daß am Ausgang des Polyphasenfilters ein Signal zur phasenrichtigen Ansteuerung des nachgeschalteten Demodulators anliegt. Hierzu kann ein Schalter vorgesehen sein, der im I- oder im Q-Pfad angeordnet sein kann. In einem Normalbetrieb dient das Polyphasenfilter zum Herausfiltern von Spiegelfrequenzen.

Die Referenzfrequenz zur Zuführung an den Demodulatoreingang kann in einer vorteilhaften Ausführungsform der vorliegenden Erfindung aus der üblicherweise ohnehin vorhandenen Referenz-Oszillator-Frequenz des Empfängers heruntergeteilt werden. Hierzu kann der Hochfrequenz-Empfänger einen Referenzoszillator aufweisen, dem ein Teiler nachgeschaltet ist, der mit dem Demodulator-Eingang verbunden ist.

Weitere Einzelheiten der vorliegenden Erfindung sind in den Unteransprüchen angegeben.

Die Erfindung wird nachfolgend an Ausführungsbeispielen anhand der Zeichnungen näher erläutert.

Es zeigen:
- Figur 1: ein Prinzipschaltbild einer Schaltungsanordnung zur Toleranzkorrektur,
- Figur 2: ein Prinzipschaltbild einer Schaltungsanordnung gemäß Figur 1 bei Anwendung in einem Hochfrequenz-Empfänger,
- Figur 3: ein weiteres Prinzipschaltbild einer Schaltungsanordnung gemäß Figur 2, und
- Figur 4: ein Prinzipschaltbild einer Schaltungsanordnung gemäß Figur 2 bei Anwendung in einem HF-Empfänger mit I- und Q-Pfaden.

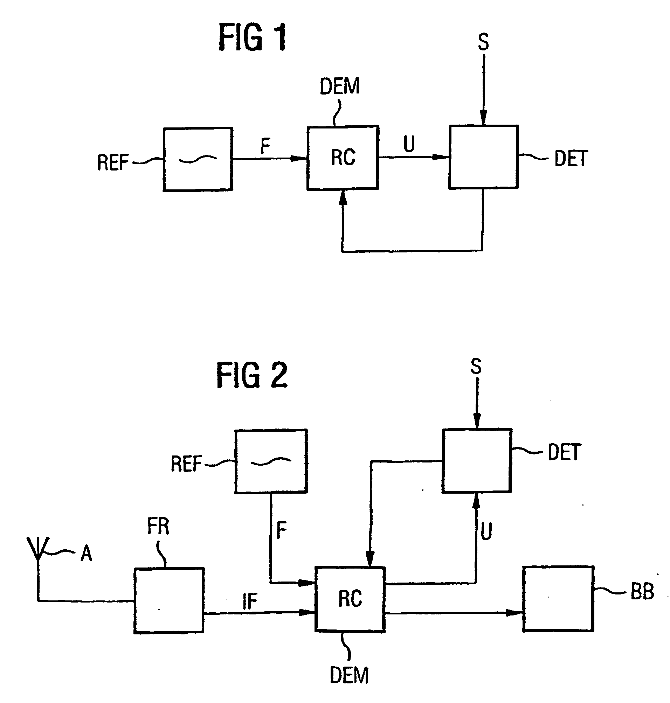

Figur 1 zeigt einen Demodulator DEM, dem ein Referenzgenerator REF vorgeschaltet und ein Detektor DET nachgeschaltet ist.

Der Demodulator DEM weist einen einstellbaren Widerstand R und eine einstellbare Kapazität C auf, welche toleranzbehaftet sein können. Folglich ist auch ein RC-Produkt RC aus Widerstandswert R und Kapazitätswert C toleranzbehaftet. Im Referenzgenerator REF ist eine Referenzfrequenz F erzeugbar, welche dem Demodulator DEM an seinem Eingang zuführbar ist. Eine am Demodulator DEM ausgangsseitig anliegende Spannung U kann einem Detektor DET zugeführt werden, wo sie mit einer dem Detektor DET ebenfalls zuführbaren Sollspannung S vergleichbar ist. Die Sollspannung S kann 0 Volt betragen. In Abhängigkeit von der Abweichung der bei Anliegen der Referenzfrequenz F am Eingang des Demodulators DEM an dessen Ausgang ableitbaren Spannung U von der Sollspannung S werden der Widerstand R und die Kapazität C im Demodulator eingestellt.

Das vorliegende Prinzip weist den Vorteil auf, daß eine Toleränzkorrektur der Widerstands- und Kapazitätswerte ermöglicht ist, und somit alle vom Produkt aus Widerstandswert und Kapazitätswert abhängigen Schaltungsparameter, beispielsweise charakteristische Frequenzen wie Mittenfrequenzen oder Grenzfrequenzen bezüglich Abweichungen von Soll- oder Nominalwerten korrigierbar sind.

Figur 2 zeigt ein Ausführungsbeispiel der vorliegenden Erfindung gemäß Figur 1 in einem Hochfrequenz-Empfänger. Dieser weist ein Frontend FR auf, an das eine Antenne A angeschlossen ist, sowie ein Zwischenfrequenzpfad mit einer Zwischenfrequenz IF. Dem Frontend FR ist ein Demodulator DEM nachgeschaltet, sowie ein Basisband-Baustein BB. In einem Normalbetrieb ist dem Demodulator DEM ein an der Antenne A einkoppelndes und im Frontend FR aufbereitetes Nutzsignal zuführbar, das im Demodulator DEM demoduliert und einem Basisband-Baustein BB zugeführt werden kann. In einem Einstellbetrieb, der einem Nutzbetrieb oder Normalbetrieb vorausgehen kann, erfolgt eine Umschaltung zwischen einem am Eingang zuführbaren Zwischenfrequenz-Signal und einem Referenzsignal dadurch, daß ein Umschalter vorgesehen ist oder die Versorgungsspannung des jeweils vorgeschalteten Blocks Frontend FR oder Frequenzgenerator REF abschaltbar ist.

Figur 2 zeigt, daß mit geringem Aufwand und einer geringen Anzahl zusätzlicher Bauelemente das beschriebene Prinzip der RC-Toleranzkorrektur, mit der sowohl Abweichungen eines Widerstands von einem Sollwert als auch einer Kapazität von einem Sollwert kompensierbar sind, in einem Hochfrequenz-Empfänger realisierbar ist.

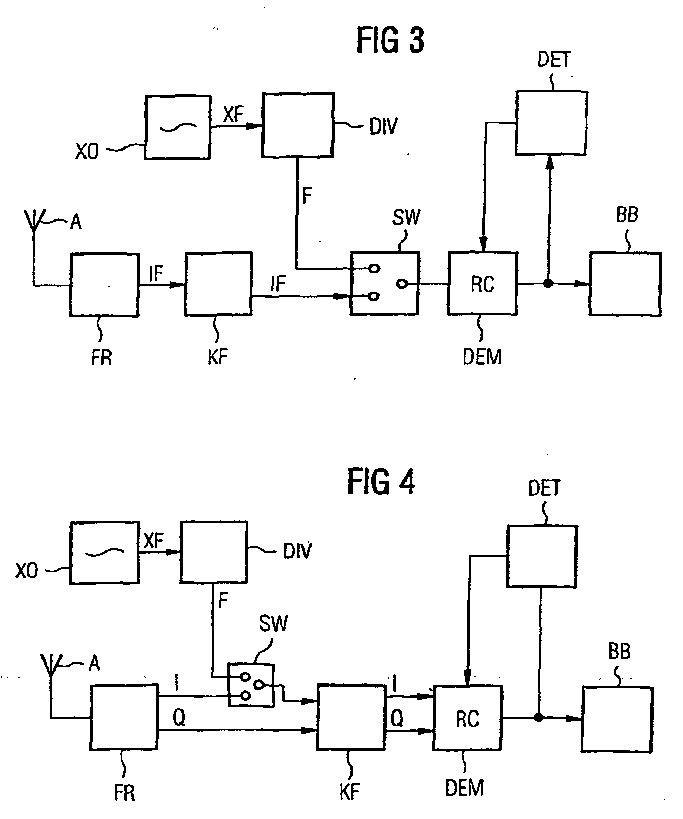

Figur 3 zeigt ein Ausführungsbeispiel der Erfindung gemäß Figur 2, bei dem die Referenzfrequenz F an einem Teiler DIV ableitbar ist, der an einen Referenz-Oszillator XO angeschlossen ist. Am Referenz-Oszillator XO ist eine Referenz-Oszillator-Frequenz XF ableitbar. Die Referenzfrequenz F kann somit bei Vorliegen einer niedrigen Zwischenfrequenz, welche beispielsweise ein Megahertz betragen kann, aus einem Systemtakt mit der Referenz-Oszillator-Frequenz XF heruntergeteilt werden. Zur Umschaltung zwischen Referenzfrequenz F und Nutzsignal auf der Zwischenfrequenz-Ebene IF ist dem Demodulator DEM ein Umschalter SW vorgeschaltet. Zwischen Frontend FR und Umschalter SW ist ein Kanalfilter KF angeordnet, welches zum Herausfiltern von bei Superheterodyn-Empfängern üblicherweise auftretenden Spiegelfrequenzen dient. Das Ableiten der Referenzfrequenz aus einem Systemtakt hat den Vorteil, daß die zur RC-Toleranzkorrektur erforderlichen Modifikationen einer Empfängerschaltung gering und einfach realisierbar sind.

In Abweichung der Schaltungsanordnung gemäß Figur 3 ist die Zwischenfrequenzebene gemäß Figur 4 in zwei Pfade für die Quadraturkomponenten I, Q aufgeteilt. Der Teiler DIV aus Figur 3 ist in Figur 4 an einem Schalter SW im I-Pfad zwischen Frontend FR und Kanalfilter KF angeordnet. Von Bedeutung ist hierbei die Anordnung des Schalters SW eingangsseitig am Kanalfilter KF. Denn das Kanalfilter KF, welches in einem Normalbetrieb zum Filtern von Spiegelfrequenzen dient, kann in einem Einstellbetrieb zugleich zur phasenrichtigen Ansteuerung des Demodulators DEM mit der Referenzfrequenz F dienen. Das Kanalfilter KF kann ein Polyphasenfilter sein.

## Patentansprüche

1. Schaltungsanordnung zur Toleranzkorrektur in einem Frequenzdemodulator (DEM), aufweisend
- den Frequenzdemodulator (DEM) mit einem einstellbaren Widerstand (R) oder einer einstellbaren Kapazität (C) und mit einem Eingang und einem Ausgang und
- einen Detektor (DET) zur Ermittlung einer Frequenzabweichung des Frequenzdemodulators (DEM) bezogen auf eine Referenzfrequenz (F), der an den Ausgang des Frequenzdemodulators (DEM) angeschlossen ist und der mit dem Frequenzdemodulator (DEM) zur Einstellung der Kapazität (C) oder des Widerstands (R) in Abhängigkeit von einer Abweichung eines Ausgangssignals des Frequenzdemodulators (DEM) von einem erwarteten Sollsignal bei Anlegen der Referenzfrequenz (F) verbunden ist.

2. Schaltungsanordnung nach Anspruch 1,
**dadurch gekennzeichnet, daß**
der Frequenzdemodulator (DEM) einen einstellbaren Widerstand (R) und eine einstellbare Kapazität (C) aufweist, und daß der Detektor (DET) mit dem Frequenzdemodulator (DEM) zur Einstellung der Kapazität (C) und des Widerstands (R) verbunden ist.

3. Schaltungsanordnung nach Anspruch 1 oder 2,
**dadurch gekennzeichnet, daß**
der Frequenzdemodulator (DEM) ein Frequenz-Demodulator ist, der der Frequenz (F) eines am Eingang anliegenden Signals eine am Ausgang abgreifbare Spannung (U) zuordnet.

4. Schaltungsanordnung nach Anspruch 3,
**dadurch gekennzeichnet, daß**
ein Frequenz-Generator (REF) zur Erzeugung der Referenzfrequenz (F) an den Eingang des Frequenzdemodulators (DEM) angeschlossen ist.

5. Schaltungsanordnung nach Anspruch 4,
**dadurch gekennzeichnet, daß** der Frequenzdemodulator (DEM) eine Soll-Mittenfrequenz hat, und daß die Soll-Mittenfrequenz gleich der Referenzfrequenz (F) ist.

6. Schaltungsanordnung nach Anspruch 3, 4 oder 5,
**dadurch gekennzeichnet, daß** dem Detektor (DET) eine Sollspannung (S) zum Vergleich mit der Ausgangsspannung (U) zuführbar ist.

7. Schaltungsanordnung nach Anspruch 6,
**dadurch gekennzeichnet, daß** die Sollspannung (S) 0 Volt beträgt.

8. Schaltungsanordnung nach einem der Ansprüche 1 bis 7,
**dadurch gekennzeichnet, daß** der Frequenzdemodulator (DEM) weitere Kondensatoren aufweist, die dem Kondensator (C) zuschaltbar sind, oder weitere Widerstände aufweist, die dem Widerstand (R) zuschaltbar sind.

9. Schaltungsanordnung nach einem der Ansprüche 1 bis 8,
**dadurch gekennzeichnet, daß** der Frequenzdemodulator (DEM) in einem Zwischenfrequenzpfad (IF, I, Q) eines Hochfrequenz-Empfängers angeordnet ist.

10. Schaltungsanordnung nach Anspruch 4 und 9,
**dadurch gekennzeichnet, daß** der Hochfrequenz-Empfänger einen Referenz-Oszillator (XO) aufweist, dem ein Teiler (DIV) nachgeschaltet ist, der mit dem Eingang des Frequenzdemodulators (DEM) verbunden ist.

11. Schaltungsanordnung nach Anspruch 4,
**dadurch gekennzeichnet, daß** dem Frequenzdemodulator (DEM) ein Kanalfilter (KF) vorgeschaltet ist, dem die Referenzfrequenz (F) zuführbar ist.

12. Schaltungsanordnung nach einem der Ansprüche 1 bis 11,
**dadurch gekennzeichnet, daß**
an den Detektor (DET) zumindest ein weiteres Bauelement mit einem einstellbaren Widerstand oder einer einstellbaren Kapazität angeschlossen ist, welche in Abhängigkeit von der Einstellung der Kapazität (C) oder des Widerstands (R) des Frequenzdemodulators (DEM) einstellbar sind.

## Claims

1. Circuit arrangement for tolerance correction in a frequency demodulator (DEM), having
- the frequency demodulator (DEM) with a variable resistor (R) or a variable capacitor (C), and having an input and an output,
- a detector (DET) for determining any frequency error in the frequency demodulator (DEM) from a reference frequency (F), which detector (DET) is connected to the output of the frequency modulator (DEM) and is connected to the frequency modulator (DEM) in order to adjust the capacitor (C) or the resistance (R) as a function of any discrepancy between an output signal from the frequency demodulator (DEM) and the expected nominal signal when the reference frequency (F) is applied.

2. Circuit arrangement according to Claim 1,
**characterized in that**
the frequency demodulator (DEM) has a variable resistor (R) and a variable capacitor (C), and **in that** the detector (DET) is connected to the frequency demodulator (DEM) in order to adjust the capacitor (C) and the resistor (R).

3. Circuit arrangement according to Claim 1 or 2,
**characterized in that**
the frequency demodulator (DEM) is a frequency demodulator, which associates the frequency (F) of a signal which is applied to the input with a voltage (U) which can be tapped off at the output.

4. Circuit arrangement according to Claim 3,
**characterized in that**
a frequency generator (REF) for producing the reference frequency (F) is connected to the input of the frequency demodulator (DEM).

5. Circuit arrangement according to Claim 4,
**characterized in that**
the frequency demodulator (DEM) has a nominal mid-frequency, and **in that** the nominal mid-frequency is equal to the reference frequency (F).

6. Circuit arrangement according to Claim 3, 4 or 5,
**characterized in that**
the detector (DET) can be supplied with a nominal voltage (S) for comparison with the output voltage (U).

7. Circuit arrangement according to Claim 6,
**characterized in that**
the nominal voltage (S) is 0 volts.

8. Circuit arrangement according to one of Claims 1 to 7,
**characterized in that**
the frequency demodulator (DEM) has further capacitors, which can be connected to the capacitor (C), or has further resistors which can be connected to the resistor (R).

9. Circuit arrangement according to one of Claims 1 to 8,
**characterized in that**
the frequency demodulator (DEM) is arranged in a intermediate-frequency path (IF, I, Q) of a radio-frequency receiver.

10. Circuit arrangement according to Claims 4 and 9,
**characterized in that**
the radio-frequency receiver has a reference oscillator (XO), which is followed by a divider (DIV) which is connected to the input of the frequency demodulator (DEM).

11. Circuit arrangement according to Claim 4,
**characterized in that**
a channel filter (KF) to which the reference frequency (F) can be supplied is connected upstream of the frequency demodulator (DEM).

12. Circuit arrangement according to one of Claims 1 to 11,
**characterized in that**
the detector (DET) is connected to at least one further component having a variable resistance or a variable capacitance, which can be adjusted as a function of the setting of the capacitance (C) or of the resistance (R) of the frequency demodulator (DEM).

## Revendications

1. Montage de correction de tolérances dans un démodulateur (DEM) de fréquence comportant
- le démodulateur (DEM) de fréquence ayant une résistance (R) réglable ou une capacité (C) réglable et ayant une entrée et une sortie ; et
- un détecteur (DET) de détermination d'un écart de fréquence du démodulateur (DEM) de fréquence par rapport à une fréquence (F) de référence, qui est raccordé à la sortie du démodulateur (DEM) de fréquence et qui est relié au démodulateur (DEM) de fréquence pour régler la capacité (C)
ou la résistance (R) en fonction d'un écart éntre un signal de sortie du démodulateur (DEM) de fréquence et un signal de consigne auquel on s'attend lors de l'application de la fréquence (F) de référence.

2. Montage suivant la revendication 1,
**caractérisé en ce que** le démodulateur (DEM) de fréquence a une résistance (R) réglable et une capacité (C) réglable et **en ce que** le détecteur (DET) est relié au démodulateur (DEM) de fréquence pour régler la capacité (C) et la résistance (R).

3. Montage suivant la revendication 1 ou 2,
**caractérisé en ce que** le démodulateur (DEM) de fréquence est un démodulateur de fréquence, qui associe une tension (U) pouvant être prélevée à la sortie à la fréquence (F) d'un signal s'appliquant à l'entrée.

4. Montage suivant la revendication 3,
**caractérisé en ce qu'**un générateur (REF) de fréquence de production (F) de la fréquence de référence est raccordé à l'entrée du démodulateur (DEM) de fréquence.

5. Montage suivant la revendication 4,
**caractérisé en ce que** le démodulateur (DEM) de fréquence a une fréquence médiane de consigne et **en ce que** la fréquence médiane de consigne est égale à la fréquence (F) de référence.

6. Montage suivant la revendication 3, 4 ou 5,
**caractérisé en ce qu'**une tension (S) de consigne peut être appliquée au détecteur (DET) pour comparaison à la tension (U) de sortie.

7. Montage suivant la revendication 6,
**caractérisé en que** la tension (S) de consigne est égale à 0 volt.

8. Montage suivant l'une des revendications 1 à 7,
**caractérisé en ce que** le démodulateur (DEM) de fréquence a d'autres condensateurs qui peuvent être connectés au condensateur (C) ou d'autres résistantes qui peuvent être connectées à la résistance (R).

9. Montage suivant l'une des revendications 1 à 8,
**caractérisé en ce que** le démodulateur (DEM) de fréquence est disposé dans un trajet (IF, I, Q) de fréquence intermédiaire d'un récepteur de haute fréquence.

10. Montage suivant la revendication 4 et 9,
**caractérisé en ce que** le récepteur de haute fréquence comporte un oscillateur (XO) de référence en aval duquel est monté un diviseur (DIV) qui est relié à l'entrée du démodulateur (DEM) de fréquence.

11. Montage suivant la revendication 4,
**caractérisé en ce qu'**il est monté en amont du démodulateur (DEM) de fréquence un filtre (KF) de canal auquel peut être envoyée la fréquence (F) de référence.

12. Montage suivant l'une des revendications 1 à 11,
**caractérisé en ce qu'**il est raccordé au détecteur (DET) au moins un autre composant ayant une résistance réglable ou une capacité réglable qui peut être réglé en fonction du réglage de la capacité (C) ou de la résistance (R) du démodulateur (DEM) de fréquence.
